Europäisches Patentamt

(19) European Patent Office

Office européen des brevets

(11) Publication number : **0 398 065 B1**

## (12) EUROPEAN PATENT SPECIFICATION

(45) Date of publication of patent specification :
**19.07.95 Bulletin 95/29**

(51) Int. Cl.[6] : **H03F 3/45**

(21) Application number : **90108192.7**

(22) Date of filing : **28.04.90**

(54) **Monolithically integratable differential operational amplifier.**

(30) Priority : **19.05.89 IT 2055989**

(43) Date of publication of application :
**22.11.90 Bulletin 90/47**

(45) Publication of the grant of the patent :
**19.07.95 Bulletin 95/29**

(84) Designated Contracting States :
**DE FR GB NL SE**

(56) References cited :
**RADIO FERNSEHEN ELEKTRONIK. vol. 27, no. 12, December 1978, BERLIN DD pages 801-803 ; M. Seifart, R. Born : "Gegengekoppelte Gleichspannungsdifferenzverstärkermit hoher Gleichtaktunterdrückung"**
**PATENT ABSTRACTS OF JAPAN vol. 6, no. 107 (E-117)(985) 17 June 1982, & JP-A-57 38008 (HITACHI SEISAKUSHO K.K.) 3 February 1982,**
**PATENT ABSTRACTS OF JAPAN vol. 10, no. 201 (E-419)(2257) 15 July 1986, & JP-A-61 43005 (ROHM CO LTD) 3 January 1986,**

(73) Proprietor : **SGS-THOMSON MICROELECTRONICS S.r.l.**
**Via C. Olivetti, 2**
**I-20041 Agrate Brianza (Milano) (IT)**

(72) Inventor : **Pasetti, Mauro**
**16/8 Via F. lli Rizzardi**
**I-20151 Milano (IT)**
Inventor : **Lagana, Paolo**
**1, Via Clefi**
**I-20146 Milano (IT)**

(74) Representative : **Spandonari, Carlo, Dr. Ing. et al**
**c/o Internazionale Brevetti INGG. ZINI, MARANESI & C. S.r.l.**
**Piazza Castello 1**
**I-20121 Milano (IT)**

## Description

The present invention relates to a monolithically integratable operational amplifier with balanced input and imbalanced output.

Known operational amplifiers have an input impedance which depends on the series resistor connected to the input and (as will become apparent hereafter) on the feedback network used. In order to ensure high input impedance in any case, it is necessary to use high-value resistors in series to the input, thus compromising precision in gain, not to mention the greater area used on the wafer of the integrated circuit.

The aim of the invention is to provide an operational amplifier which can be integrated monolithically, with balanced input and imbalanced output, which has high input impedance and very accurate gain without requiring high-value resistors and which furthermore has a wide dynamic range without however having higher power consumption.

The invention achieves this aim and other objects and advantages, as will become apparent from the continuation of the description, with a differential operational amplifier, as defined in claim 1.

The invention is now described in greater detail with reference to a preferred embodiment thereof, illustrated only by way of non-limitative example in the accompanying drawings, wherein:

figure 1 is a circuit diagram of an operational amplifier according to the prior art; and

figure 2 is a circuit diagram of an operational amplifier according to the invention.

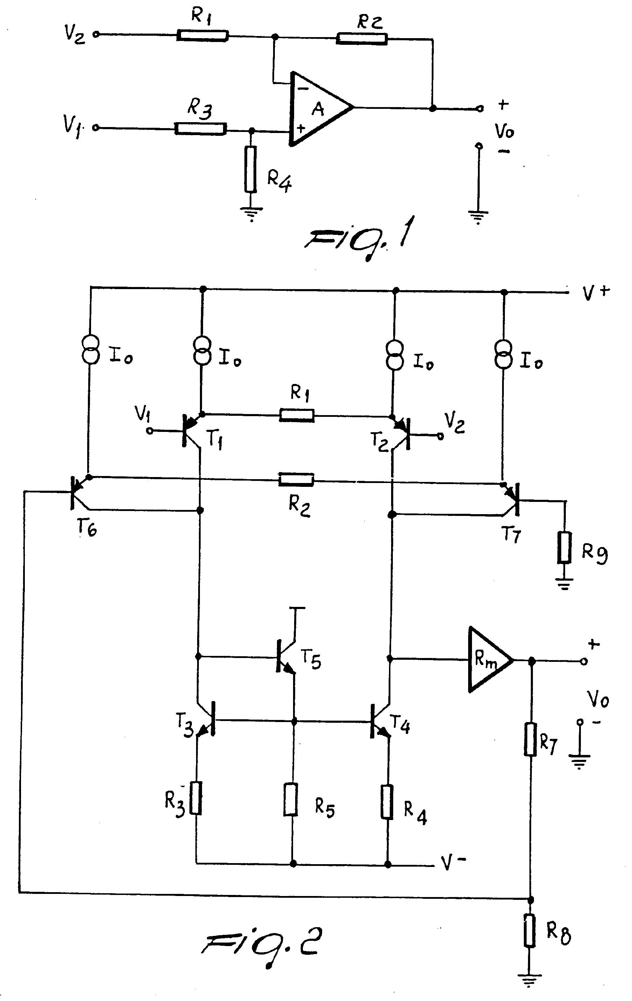

In figure 1, which illustrates a conventional operational amplifier, A indicates a conventional differential gain stage, compensated by means of the Miller effect, which has a biasing resistor $R_4$, a feedback resistor $R_2$ and two input resistors $R_1$ and $R_3$ connected in series to the respective inputs. As is known, if $V_1$ and $V_2$ are the voltage signals at the inputs, and $V_0$ is the voltage at the output, the gain of the circuit is

$$V_0 = (V_2 - V_1) R_2/R_1,$$

with

$$R_2/R_1 = R_4/R_3.$$

The impedance seen by the generators $V_1$ and $V_2$ depends on the feedback network and therefore on the gain to be achieved. It would be necessary to use high-value resistors, which however negatively affect accuracy in gain and area occupation.

Since $R_1$ constitutes a load for the input voltage $V_2$, a decoupling (or buffer) circuit is often used ahead of the amplifier of figure 1.

Figure 2 illustrates an operational amplifier according to the preferred embodiment of the invention, fed by supply voltages $V^+$, $V^-$. A conventional transresistance stage $R_m$ is preceded by a first input differential stage which comprises two bipolar PNP transistors $T_1$ and $T_2$ with their emitters connected to one another by a resistor $R_1$ and biased by respective current generators $I_o$, and with their collectors charged by respective bipolar NPN transistors $T_3$, $T_4$ the emitters whereof are connected to the voltage $V^-$ across respective resistors $R_3$, $R_4$. An NPN transistor $T_5$ is common-emitter connected, with its base driven by the collector of the transistor $T_3$ and with a resistive load $R_5$ which drives both bases of the transistors $T_3$, $T_4$, so as to constitute a current mirror which ensures the balancing of the first input differential stage. The bases of the two transistors $T_1$, $T_2$ are the input terminals of the overall system, to which input voltages $V_1$, $V_2$ are applied, and the collector of the transistor $T_2$ is the output node of the input differential stage which drives the gain stage $R_m$.

The transresistance gain stage $R_m$ can be any conventional transresistance stage as normally used in operational amplifiers. In its most rudimentary form, it can be constituted by a simple common-emitter-connected transistor.

The above described circuit is furthermore provided with a feedback which comprises a second differential stage formed by two bipolar PNP transistors $T_6$, $T_7$ with their emitters connected to one another by a resistor $R_2$ and biased by respective current generators $I_o$, and with their collectors connected to the respective collectors of $T_1$, $T_2$. The output of the gain stage A drives, across a divider formed by resistors $R_7$, $R_8$, the base of $T_6$, whereas the base of $T_7$ is connected to the ground across a resistor $R_9$ equal in value to the equivalent resistance of the parallel connection of $R_7$, $R_8$ in order to equal the impedances seen by the bases of $T_7$ and $T_6$, thus minimizing offset.

It can be easily seen that in the above described circuit the relation between the output voltage $V_0$ and the input voltages $V_1$ and $V_2$ is:

$$V_o = (V_2 - V_1) \frac{R_2 + 2r_{e2}}{R_1 + 2r_{e1}} \left( 1 + \frac{R_7}{R_8} \right)$$

where $r_{e1}$ and $r_{e2}$ are the emitter resistances for the transistors $T_1$, $T_2$ and $T_6$, $T_7$ respectively.

The use of a double input differential stage allows not to load the signal sources $V_1$, $V_2$, whereas the resistive feedback between the output and the second differential stage adds a degree of freedom in the provision of the required gain. This makes the circuit according to the invention usable for whatever gain is to be provided, since $R_1$ and $R_2$ can be equal, thus eliminating the effects of parametric variations and of $r_{e1}$ and $r_{e2}$ on the precision of the gain, and is thus provided on $R_7$ and $R_8$, which can be chosen arbitrarily without affecting the characteristic parameters of the operational amplifier and without requiring modification of its structure.

The only parameter affected by the absolute values of $R_7$ and $R_8$ is the output impedance; the effect on this parameter can in any case only be positive since the series of $R_7$ and $R_8$ is in parallel to said output impedance (which is in any case low) of the output stage of the stage $R_m$.

The invention has other advantages which can be especially appreciated in terms of the monolithic integration of the circuit. Gain in fact depends on a resistive ratio and therefore allows high precision and independence with respect to the typical parametric variations. High resistive values are furthermore not required, to the greater advantage of gain accuracy and of the semiconductor area required for integration.

A preferred embodiment of the invention has been described by way of example, but it is evident that equivalent modifications and variations, which are obvious to the expert in the field, are possible within the scope of the claims.

## Claims

1. Differential operational amplifier, characterized in that it, comprises:

   a transresistance gain stage (Rm);

   a first input differential stage which comprises a first pair of transistors ($T_1$,$T_2$) the bases whereof can be driven by respective input signals ($V_1$,$V_2$); and

   a second differential stage which comprises a second pair of transistors ($T_6$,$T_7$) having their respective collectors connected to respective collectors of said first pair of transistors, one of the collectors of said first pair of transistors ($T_1$, $T_2$) being connected to the input terminal of the gain state ($R_m$), said first and said second pair of transistor having their respective emitters operatively connected to a voltage supply line ($V^+$), a base of a first transistor ($T_6$) of said second pair of transistors being driven by an output signal of said gain stage via a first resistor ($R_7$), a second resistor ($R_8$) being interposed between said base of said first transistor of said second pair of transistors and the ground, a base of a second transistor ($T_7$) of said second pair of transistors being connected to the ground via a third resistor ($R_9$) which is equal in value to the equivalent resistance of the parallel connection of said first resistor and of said second resistor.

2. The Differential operational amplifier according to claim 1, characterized in that the transistors of said first and second pairs ($T_1$,$T_2$,$T_6$,$T_7$) have respective emitters biased by respective current generators ($I_0$).

3. The differential operational amplifier according to claims 1 or 2, characterized in that a fourth resistor ($R_1$) mutually connects the emitters of the transistors of said first pair ($T_1$,$T_2$).

4. The differential operational amplifier according to one or more of the preceding claims, characterized in that a fifth resistor ($R_2$) mutually connects the emitters of the transistors of said second pair ($T_6$,$T_7$).

5. The differential operational amplifier according to one or more of the preceding claims, characterized in that the transistors of said first and second pairs ($T_1$,$T_2$,$T_6$,$T_7$) have respective collectors which have as common load a current mirror ($T_3$,$T_4$,$T_5$,$R_3$,$R_4$,$R_8$).

**Patentansprüche**

1. Operationsdifferenzverstärker, dadurch gekennzeichnet, daß er enthält:
   eine Transresistanzverstärkerstufe ($R_m$);
   eine erste Eingangsdifferenzstufe, die ein erstes Paar von Transistoren ($T_1$, $T_2$) enthält, deren Basen durch entsprechende Eingangssignale ($V_1$, $V_2$) angesteuert werden können, und
   eine zweite Differenzstufe, die ein zweites Paar von Transistoren ($T_6$, $T_7$) aufweist, deren jeweilige Kollektoren an die entsprechenden Kollektoren des ersten Transistorpaares angeschlossen sind, wobei einer der Kollektoren des ersten Transistorpaars ($T_1$, $T_2$) an den Eingangsanschluß der Verstärkerstufe ($R_m$) angeschlossen ist, das erste und zweite Transistorpaar mit ihren jeweiligen Emittern betriebsmäßig an eine Spannungsversorgungsleitung ($V^+$) angeschlossen sind, eine Basis eines ersten Transistors ($T_6$) des zweiten Transistorpaares über einen ersten Widerstand ($R_7$) durch ein Ausgangssignal der Verstärkerstufe angesteuert wird, ein zweiter Widerstand ($R_8$) zwischen die Basis des ersten Transistors des zweiten Transistorpaares und Masse geschaltet ist und eine Basis eines zweiten Transistors ($T_7$) des zweiten Transistorpaares über einen dritten Widerstand ($R_9$) an Masse geschaltet ist, dessen Widerstandsswert den gleichen Betrag hat, wie der äquivalente Widerstandswert der Parallelschaltung des erstem Widerstands und des zweiten Widerstands.

2. Operationsdifferenzverstärker nach Anspruch 1, dadurch gekennzeichnet, daß die Transistoren des ersten und zweiten Transistorpaars ($T_1$, $T_2$, $T_6$, $T_7$) jeweils Emitter haben, die durch zugehörige Stromgeneratoren vorgespannt sind.

3. Operationsdifferenzverstärker nach Anspruch 1 oder 2, dadurch gekennzeichnet, daß ein vierter Widerstand ($R_1$) die Emitter der Transistoren des ersten Transistorpaars ($T_1$, $T_2$) miteinander verbindet.

4. Operationsdifferenzverstärker nach einem oder mehreren der vorhergehenden Ansprüche, dadurch gekennzeichnet, daß ein fünfter Widerstand ($R_2$) die Emitter der Transistoren des zweiten Transistorpaars ($T_6$, $Z_7$) miteinander verbindet.

5. Operationsdifferenzverstärker nach einem oder mehreren der vorhergehenden Ansprüche, dadurch gekennzeichnet, daß die Transistoren des ersten und zweiten Transistorpaars ($T_1$, $T_2$, $T_6$, $T_7$) jeweils Kollektoren haben, die als gemeinsame Last einen Stromspiegel ($T_3$, $T_4$, $T_5$, $R_3$, $R_4$, $R_5$) haben.

**Revendications**

1. Amplificateur opérationnel différentiel caractérisé en ce qu'il comprend :
   un étage de gain courant-tension (Rm) ;
   un premier étage d'entrée différentiel qui comprend une première paire de transistors ($T_1$, $T_2$) dont les bases peuvent être pilotées par des signaux d'entrée respectifs ($V_1$, $V_2$) ; et
   un deuxième étage différentiel qui comprend une deuxième paire de transistors ($T_6$, $T_7$) ayant leurs collecteurs respectifs connectés aux collecteurs respectifs de la première paire de transistors, l'un des collecteurs de la première paire de transistors ($T_1$, $T_2$) étant connecté à la borne d'entrée de l'étage de gain (Rm), les transistors des première et deuxième paires ayant leurs émetteurs respectifs connectés opérativement à une ligne d'alimentation en tension ($V^+$), la base d'un premier transistor ($T_6$) de la deuxième paire de transistors étant pilotée par un signal de sortie de l'étage de gain par l'intermédiaire d'une première résistance ($R_7$), une deuxième résistance ($R_8$) étant interposée entre la base du premier transistor de la deuxième paire de transistors et la masse, la base d'un deuxième transistor ($T_7$) de la deuxième paire de transistors étant connectée à la masse par l'intermédiaire d'une troisième résistance ($R_9$) qui a une valeur égale à la résistance équivalente de la connexion en parallèle des première et deuxième résistances.

2. Amplificateur opérationnel différentiel selon la revendication 1, caractérisé en ce que les transistors des première et deuxième paires ($T_1$, $T_2$, $T_6$, $T_7$) ont des émetteurs respectifs polarisés par des générateurs de courant respectifs ($I_0$).

3. Amplificateur opérationnel différentiel selon la revendication 1 ou 2, caractérisé en ce qu'un quatrième transistor ($R_1$) relie les émetteurs des transistors de la première paire ($T_1$, $T_2$).

4. Amplificateur opérationnel différentiel selon une ou plusieurs des revendications précédentes, caractérisé en ce qu'une cinquième résistance ($R_2$) relie les émetteurs des transistors de la deuxième paire ($T_6$, $T_7$).

5. Amplificateur opérationnel différentiel selon une ou plusieurs des revendications précédentes, caractérisé en ce que les transistors des première et deuxième paires ($T_1$, $T_2$, $T_6$, $T_7$) ont des collecteurs respectifs qui ont pour charge commune un miroir de courant ($T_3$, $T_4$, $T_5$, $R_3$, $R_4$, $R_5$).

Fig. 1

Fig. 2